# EUROPEAN PATENT APPLICATION

(11) **EP 4 393 929 A1**
(43) Date of publication of application: **03.07.2024**
(21) Application number: 22891539.3
(22) Date of filing: 05.08.2022
(51) Int. Cl.: C07F 9/38

(54) **PEROVSKITE SOLAR CELL AND PREPARATION METHOD THEREFOR**

(30) Priority: 12.11.2021 CN 202111343015; 16.12.2021 CN 202111544558
(71) Applicant: University of Electronic Science and Technology of China, Chengdu, Sichuan 611731 (CN); Jingao Solar Co., Ltd., Xingtai, Hebei 055550 (CN)
(72) Inventor: LIU, Mingzhen, Chengdu, Sichuan 611731 (CN); MAO, Lin, Chengdu, Sichuan 611731 (CN); HU, Yuchao, Chengdu, Sichuan 611731 (CN); LI, Faming, Chengdu, Sichuan 611731 (CN); WANG, Song, Chengdu, Sichuan 611731 (CN); XU, Zhiwei, Chengdu, Sichuan 611731 (CN)
(74) Representative: ABG Intellectual Property Law, S.L.
(86) International application number: PCT/CN2022/110418
(87) International publication number: WO 2023/082730

(57) **Abstract**

Disclosed are a perovskite solar cell and a fabrication method thereof. The perovskite solar cell includes an electron transport layer, a perovskite layer, and a hole transport layer, where the hole transport layer includes an inorganic substance serving as a hole transport material, and an organic layer including a carbazole derivative is formed on the hole transport layer. A combination of a carbazole derivative and an inorganic material serving as a hole transport layer can allow the preparation of a perovskite solar cell with a high conversion efficiency.

## Description

### CROSS REFERENCE TO RELATED APPLICATION

The present application claims priority to a Chinese patent application 202111343015.4 entitled "PEROVSKITE SOLAR CELL AND FABRICATION METHOD THEREOF" and filed on November 12, 2021, and a full content disclosed in the Chinese patent application is incorporated herein as a part of the present application.

### TECHNICAL FIELD

The present application relates to a perovskite solar cell and a fabrication method thereof.

### BACKGROUND

Perovskites are minerals with a chemical composition of CaTiOs. Through years of research, scientists have discovered that not only perovskites (CaTiOs) themselves have special properties, but also materials with an ABX₃ structure similar to the CaTiO₃ structure have similar properties. The perovskite in the present application refers to a substance with an ABX₃ structure.

For example, in the field of solar cells, perovskites are widely used and studied due to their wide and adjustable light absorption ranges.

For example, in the patent document 1 (CN112103392A), a perovskite solar cell is disclosed, including a silicon bottom cell and a perovskite top cell, where an undoped Spiro-TTB (chemical name: 2,2',7,7'-tetrakis(di-p-tolylamino)spiro-9,9'-difluorene or 2,2',7,7'-tetrakis(N,N-di-p-tolyl)amino-9,9-spirodifluorene) layer is adopted as a modification layer for a hole transport material layer such as an inorganic nickel oxide layer.

However, a conversion efficiency of the perovskite solar cell in the patent document 1 still needs to be improved.

### SUMMARY

Therefore, a technical problem to be solved by the present application is to provide a perovskite solar cell that can improve s conversion efficiency, and a fabrication method thereof.

To solve the above technical problem, the present application provides the following technical solutions:
In a first aspect, the present application provides a perovskite solar cell, including an electron transport layer, a perovskite layer, and a hole transport layer, where the hole transport layer includes an inorganic substance serving as a hole transport material, and an organic layer including a carbazole derivative is formed on the hole transport layer.

Preferably, a molecular formula of the carbazole derivative includes a skeleton of carbazole molecule and an organic acid group directly or indirectly linked to nitrogen of the skeleton of carbazole molecule, where the organic acid group is preferably selected from the group consisting of phosphoryl, carboxyl, sulfonyl, sulfinyl, and thiocarboxyl, and a hydrogen atom on the skeleton of carbazole molecule is able to be substituted.

Preferably, the carbazole derivative is a compound shown in a molecular formula (I):

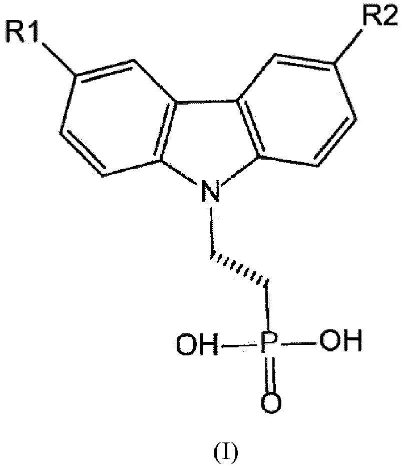

where R1 and R2 are independently selected from the group consisting of a hydrogen atom, alkyl, alkoxy, alkenyl, and alkynyl; R1 and R2 are the same or different; a dotted line represents a linking group; preferably, the linking group refers to a group linking a phosphorus atom and a nitrogen atom, for example, the linking group is selected from the group consisting of substituted or unsubstituted alkylene with 1 or more, preferably 2 or more, and more preferably 3 or more carbon atoms and substituted or unsubstituted alkenylene with 2 or more and preferably 3 or more carbon atoms, etc;
preferably, R1 and R2 are independently selected from the group consisting of methyl and methoxy; preferably, R1 and R2 both are methyl; and preferably, R1 and R2 both are a hydrogen atom.

In a second aspect, the present application provides a fabrication method of a perovskite solar cell, including the following steps:
(a) providing a substrate;
(b) forming an electron transport layer on the substrate;
(c) forming a perovskite layer on the electron transport layer; and
(d) forming a hole transport layer on the perovskite layer, and forming an organic layer including a carbazole derivative on the hole transport layer, where the hole transport layer includes an inorganic substance serving as a hole transport material;
   or

(a) providing a substrate;
(b) forming a hole transport layer on the substrate, and forming an organic layer including a carbazole derivative on the hole transport layer, where the hole transport layer includes an inorganic substance serving as a hole transport material;
(c) forming a perovskite layer on the organic layer on the hole transport layer; and
(d) forming an electron transport layer on the perovskite layer.

Preferably, a molecular formula of the carbazole derivative includes a skeleton of carbazole molecule and an organic acid group directly or indirectly linked to nitrogen of the skeleton of carbazole molecule, where the organic acid group is preferably selected from the group consisting of phosphoryl, carboxyl, sulfonyl, sulfinyl, and thiocarboxyl, and a hydrogen atom on the skeleton of carbazole molecule is able to be substituted.

Preferably, the carbazole derivative is a compound shown in a molecular formula (I):

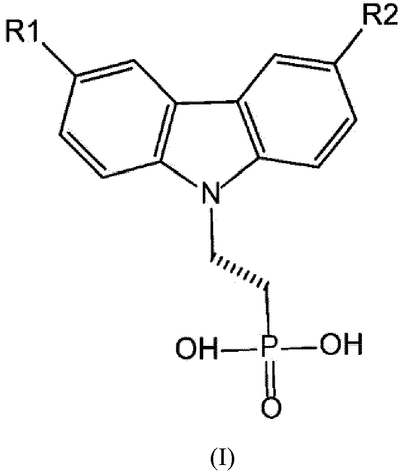

where R1 and R2 are independently selected from the group consisting of a hydrogen atom, alkyl, alkoxy, alkenyl, and alkynyl; R1 and R2 are the same or different; a dotted line represents a linking group; preferably, the linking group refers to a group linking a phosphorus atom and a nitrogen atom, for example, the linking group is selected from the group consisting of substituted or unsubstituted alkylene with 1 or more, preferably 2 or more, and more preferably 3 or more carbon atoms and substituted or unsubstituted alkenylene with 2 or more and preferably 3 or more carbon atoms, etc;
preferably, R1 and R2 are independently selected from the group consisting of methyl and methoxy; preferably, R1 and R2 both are methyl; and preferably, R1 and R2 both are a hydrogen atom.

In a third aspect, the present application provides a perovskite solar cell, including:
a P-type or N-type crystalline silicon solar cell as a substrate; and
an electron transport layer, a perovskite layer, and a hole transport layer or a hole transport layer, a perovskite layer, and an electron transport layer that are formed successively on a primary surface of the P-type or N-type crystalline silicon solar cell,
where the hole transport layer includes an inorganic substance serving as a hole transport material, and an organic layer including a carbazole derivative is formed on the hole transport layer.

Preferably, a molecular formula of the carbazole derivative includes a skeleton of carbazole molecule and an organic acid group directly or indirectly linked to nitrogen of the skeleton of carbazole molecule, where the organic acid group is preferably selected from the group consisting of phosphoryl, carboxyl, sulfonyl, sulfinyl, and thiocarboxyl, and a hydrogen atom on the skeleton of carbazole molecule is able to be substituted.

Preferably, the carbazole derivative is a compound shown in a molecular formula (I):

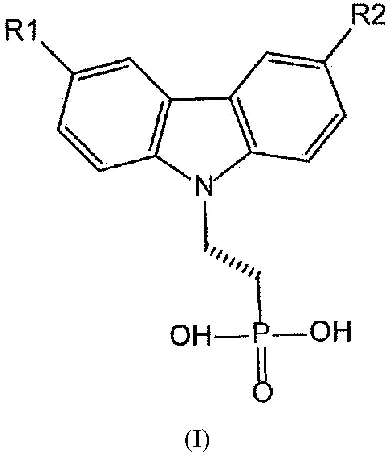

where R1 and R2 are independently selected from the group consisting of a hydrogen atom, alkyl, alkoxy, alkenyl, and alkynyl; R1 and R2 are the same or different; a dotted line represents a linking group; preferably, the linking group refers to a group linking a phosphorus atom and a nitrogen atom, for example, the linking group is selected from the group consisting of substituted or unsubstituted alkylene with 1 or more, preferably 2 or more, and more preferably 3 or more carbon atoms and substituted or unsubstituted alkenylene with 2 or more and preferably 3 or more carbon atoms, etc;
preferably, R1 and R2 are independently selected from the group consisting of methyl and methoxy; preferably, R1 and R2 both are methyl; and preferably, R1 and R2 both are a hydrogen atom.

Preferably, the P-type or N-type crystalline silicon solar cell is a heterojunction solar cell.

The present application adopts a combination of a carbazole derivative such as a compound shown in formula (I) and an inorganic material serving as a hole transport layer to prepare a perovskite solar cell with a high conversion efficiency.

### BRIEF DESCRIPTION OF THE DRAWINGS

FIG. 1 is a schematic structural diagram of a first perovskite solar cell provided in Example 1; and
FIG. 2 is a schematic structural diagram of a second perovskite solar cell provided in Example 2.

### Reference numerals:

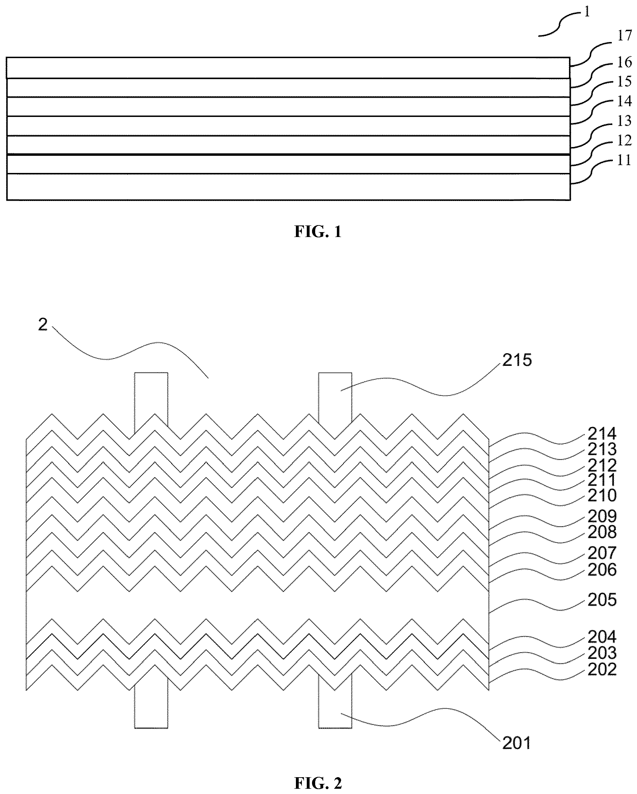

In FIG. 1:
1: First perovskite solar cell
11: Bottom electrode layer
12: Hole transport layer
13: Organic layer including a carbazole derivative
14: Perovskite layer
15: First electron transport layer
16: Second electron transport layer
17: Top electrode layer

In FIG. 2:
2: Second perovskite solar cell
201: Backside electrically-conductive grid wire
202: Backside transparent electrically-conductive layer (bottom electrode)
203: P-type amorphous silicon layer
204: First intrinsic amorphous silicon layer
205: N-type silicon substrate
206: Second intrinsic amorphous silicon layer
207: N-type amorphous silicon layer
208: Intermediate transparent electrically-conductive layer
209: Hole transport layer
210: Organic layer including a carbazole derivative
211: Perovskite layer
212: First electron transport layer
213: Second electron transport layer
214: Frontside transparent electrically-conductive layer
215: Frontside electrically-conductive grid wire

### DETAILED DESCRIPTION OF THE EMBODIMENTS

The technical solutions of the present application are described in detail below.

In a first aspect, the present application provides a perovskite solar cell, including an electron transport layer, a perovskite layer, and a hole transport layer, where the hole transport layer includes an inorganic substance serving as a hole transport material, and an organic layer including a carbazole derivative is formed on the hole transport layer.

The carbazole derivative in the present application is preferably a substance with a high purity, and the higher the purity, the better. For example, the carbazole derivative has a purity of 95.0% or more, such as 96.0%, 97.0%, 98.0%, 99.0%, or more. The so-called high purity here means that there is no need to dope the carbazole derivative with another substance such as an oxide. Since there is no need to dope the carbazole derivative with another substance, the carbazole derivative has excellent stability.

In the perovskite solar cell, an inorganic substance such as nickel oxide that can serve as a hole transport material is used to form a hole transport layer. A surface of the hole transport layer has defects. For example, other high-valence metal elements will react with organic cations (A in ABX₃) in a perovskite layer, such that components such as lead halide in the perovskite layer are enriched at an interface between the hole transport layer and the perovskite layer to produce a potential barrier. In addition, when becoming a state with an oxidizing ability, oxidizing elements such as oxygen in the hole transport layer will react with an organic cation (A in ABX₃) in the perovskite layer, and as a result, the carrier migration here will be limited, which aggravates the recombination of carriers and ultimately leads to a low open-circuit voltage and a low conversion efficiency of a cell. In the present application, a thin organic layer including the carbazole derivative can be formed on the hole transport layer to significantly improve the above situation, thereby improving properties such as a conversion efficiency of a solar cell. This is because the carbazole derivative has characteristics such as blocking electrons and screening holes, and passivating defects such as high-valence nickel and oxygen dangling bonds on a surface of a hole transport layer such as nickel oxide. Moreover, if the carbazole derivative has an organic acid group such as phosphoryl, the organic acid group can anchor a high-energy-state atom such as an oxygen atom on a surface of a metal oxide that can serve as a hole transport material, and thus the carbazole derivative can be evenly distributed on a surface of a hole transport layer merely through a simple solution contact to form strong and stable bonding, thereby reducing a work function of the surface of the hole transport layer.

In summary, the present application adopts a combination of a carbazole derivative such as a compound shown in formula (I) and an inorganic material serving as a hole transport layer to prepare a perovskite solar cell with a high conversion efficiency.

A molecular formula of the carbazole derivative includes a skeleton of carbazole molecule and an organic acid group directly or indirectly linked to nitrogen of the skeleton of carbazole molecule, where the organic acid group is preferably selected from the group consisting of phosphoryl, carboxyl, sulfonyl, sulfinyl, and thiocarboxyl, and a hydrogen atom on the skeleton of carbazole molecule is able to be substituted.

In the present application, a structure of the skeleton of carbazole molecule is shown as follows: 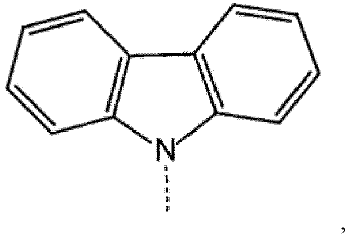 where a dotted bond "---" indicates that the skeleton of carbazole molecule can be linked to another group through an N atom.

Preferably, a benzene ring of the skeleton of carbazole molecule includes a substituent or does not include a substituent. Further, there can be 1, 2, 3, or 4 substituents in each benzene ring. The substituent can be selected from the group consisting of alkyl, alkoxy, alkenyl, and alkynyl. The alkyl and the alkoxy may include 1 to 6 carbon atoms, such as 2, 3, 4, or 5 carbon atoms. The alkenyl and the alkynyl may include 2 to 6 carbon atoms, such as 3, 4, or 5 carbon atoms.

Preferably, the carbazole derivative is a compound shown in a molecular formula (I):

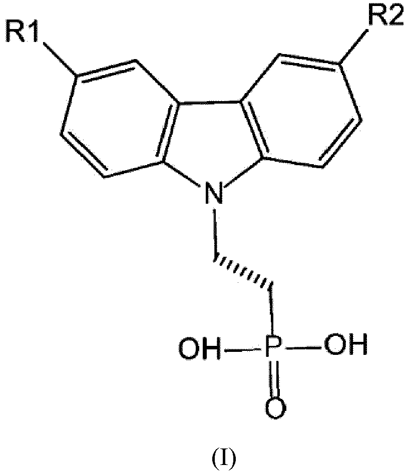

where R1 and R2 each are one selected from the group consisting of a hydrogen atom, alkyl, alkoxy, alkenyl, and alkynyl; R1 and R2 are the same or different; a dotted line represents a linking group; preferably, the linking group refers to a group linking a phosphorus atom and a nitrogen atom, for example, the linking group is selected from the group consisting of substituted or unsubstituted alkylene with 1 or more, preferably 2 or more, and more preferably 3 or more carbon atoms and substituted or unsubstituted alkenylene with 2 or more and preferably 3 or more carbon atoms, etc;
preferably, R1 and R2 each are selected from the group consisting of methyl and methoxy; preferably, R1 and R2 both are methyl; and preferably, R1 and R2 both are a hydrogen atom.

Preferably, R1 and R2 are independently selected from the group consisting of alkyl, alkoxy, alkenyl, and alkynyl. Further, the alkyl and the alkoxy may include 1 to 6 carbon atoms, such as 2, 3, 4, or 5 carbon atoms, and the alkenyl and the alkynyl may include 2 to 6 carbon atoms, such as 3, 4, or 5 carbon atoms.

Preferably, R1 and R2 are independently selected from the group consisting of linear alkyl and linear alkoxy that each have 1 to 6 carbon atoms.

Preferably, the linking group includes 1 to 6 carbon atoms, such as 2, 3, 4, or 5 carbon atoms. Preferably, the linking group can be alkylene with 1 to 6 carbon atoms. Further, the linking group can be linear alkylene with 1 to 6 carbon atoms. Preferably, the linking group can be alkenylene with 2 to 6 carbon atoms, and further, the linking group can be linear alkenylene with 2 to 6 carbon atoms.

The alkylene can be selected from the group consisting of methylene, ethylene, and butylene, etc.

Unsubstituted alkenylene can be selected from the group consisting of ethenylene and propenylene, etc.

A hydrogen atom in the alkylene can be substituted by some specific elements, for example, the hydrogen atom in the alkylene can be substituted by halogens such as fluorine, chlorine, bromine, and iodine, etc.

The inorganic substance serving as the hole transport material can be at least one or more selected from the group consisting of nickel oxide, cuprous iodide, cuprous thiocyanate, cupric oxide, cuprous oxide, and cupric sulfide.

Preferably, a thickness of the hole transport layer is more than or equal to 1 nm and less than or equal to 100 nm, such as 2 nm, 3 nm, 4 nm, 5 nm, 6 nm, 7 nm, 8 nm, 9 nm, 10 nm, 20 nm, 30 nm, 40 nm, 50 nm, 60 nm, 70 nm, 80 nm, or 90 nm; and preferably, a thickness of the organic layer including the carbazole derivative is more than or equal to 0.01 nm and less than or equal to 5 nm, such as 4.5 nm, 4 nm, 3.5 nm, 3 nm, 2.5 nm, 2 nm, 1.5 nm, 1 nm, 0.5 nm, 0.3 nm, 0.2 nm, or 0.1 nm.

It should be noted that the organic layer including the carbazole derivative in the present application should not be too thick. For example, the organic layer including the carbazole derivative has a thickness that allows a modification of a surface of the hole transport layer without contacting the hole transport layer to passivate defects on the surface of the hole transport layer. In the present application, a main function of the organic layer including the carbazole derivative is to modify or passivate the defects on the surface of the hole transport layer.

Preferably, the inorganic substance serving as the hole transport material includes nickel oxide; and preferably, the inorganic substance serving as the hole transport material is a material mainly based on nickel oxide, and is not doped with or is doped with any one or more selected from the group consisting of trivalent nickel, copper, cobalt, manganese, lanthanum, yttrium, magnesium, lithium, zinc, indium, and tin.

For example, nickel oxide is a P-type semiconductor material with a band gap of 3.8 eV and excellent transmission for near-ultraviolet and visible light. Nickel oxide has a valence band of -5.28 eV and a conduction band of -1.46 eV. The valence band of nickel oxide is close to a highest occupied molecular orbital (HOMO) energy level (about -5.30 eV) of a common perovskite such as CsFAMAPbIBr (such as Cs_{0.1}(HN=CHNH₃)_{0.8} (CH₃NH₃)_{0.1}Pb(I_{0.9}Br_{0.1})₃), which is conducive to the collection of holes. The conduction band of nickel oxide is much higher than a lowest unoccupied molecular orbital (LUMO) energy level (about -3.90 eV) of a perovskite, which can effectively block the diffusion of electrons to an electrode.

In the present application, an efficient composite hole transport layer is prepared by combining a stable structure and a strong electron-blocking ability of nickel oxide with a high hole mobility of carbazole derivative.

Nickel oxide can be prepared in a large area through physical vapor deposition, and can maintain stable properties for a long time in a complicated environment such as water, oxygen, and high-temperature environments. In addition, a high-purity nickel oxide material has a low price. However, perovskite solar cells with nickel oxide as a hole transport layer tend to exhibit a low open-circuit voltage, which is attributed to the following reasons: trivalent or higher nickel in nickel oxide will react with an organic cation in a perovskite, such that lead halide in the perovskite is enriched at an interface between the nickel oxide and the perovskite to produce a potential barrier. A hydroxyl dangling bond on a surface of the nickel oxide will also react with a cation at A in ABX₃ of the perovskite after being deprotonated, such that the carrier migration there is restricted to aggravate the recombination of carriers, resulting in poor properties such as a low open-circuit voltage of a cell. The carbazole derivative has characteristics such as blocking electrons and screening holes. Moreover, if the carbazole derivative includes phosphoryl, the phosphoryl can anchor an oxygen atom on a surface of an oxide, and thus the carbazole derivative can be evenly distributed on a surface of a lower nickel oxide layer merely through a simple solution contact to form strong and stable bonding, thereby reducing a work function of the surface.

It should be noted that the nickel oxide material can be mainly based on nickel oxide (NiO), and is not doped with or is doped with any one or more selected from the group consisting of trivalent nickel, copper, cobalt, manganese, lanthanum, yttrium, magnesium, lithium, zinc, indium, and tin.

The electron transport layer can include a first electron transport layer and/or a second electron transport layer; preferably, the first electron transport layer and/or the second electron transport layer include(s) an inorganic substance and/or an organic substance serving as an electron transport material; preferably, the inorganic substance is at least one or more selected from the group consisting of titanium dioxide (TiO₂), tin oxide (SnO₂), and zinc oxide (ZnO); and preferably, the organic substance is at least one or more selected from the group consisting of a fullerene and a derivative thereof, and more preferably, the fullerene is selected from the group consisting of a fullerene with 60 carbon atoms (a C₆₀ fullerene) and a fullerene with 70 carbon atoms (a C₇₀ fullerene).

Titanium dioxide is an electron transport material most widely used in perovskite solar cells. This is because a conduction band minimum (CBM) of titanium dioxide is -4.1 eV and is slightly lower than an LUMO energy level of CH₃NH₃PbI₃, which is conducive to the injection of electrons.

Zinc oxide is another electron transport material commonly used in perovskite solar cells. Zinc oxide is a direct band gap II-VI semiconductor material with a band gap of 3.3 eV, a CBM of -4.2 eV, and an exciton binding energy of 60 meV at room temperature. Zinc oxide matches an LUMO energy level (-3.6 eV) and an HOMO energy level (-5.2 eV) of CH₃NH₃PbI₃ in terms of energy levels, which ensures an efficiency of electron extraction. In addition, zinc oxide does not require high-temperature sintering, can be easily prepared into a large-area film, and has a higher electron mobility than titanium dioxide.

Tin oxide has excellent electrical and optical properties, such as an appropriate energy level, a high carrier mobility, and a prominent anti-reflection ability.

Preferably, the perovskite layer includes a layer of a material with an ABX₃ structure, wherein
A is a first cation, including, but not limited to, Rb⁺, Na⁺, K⁺, Ca²⁺, Ba²⁺, Cs⁺, HN=CHNH₃⁺, CH₃NH₃⁺, Pb²⁺, Sr²⁺, Sn²⁺, or a combination thereof,
B is a second cation, including, but not limited to, Ti⁴⁺, Nb⁵⁺, Mn⁴⁺, Fe³⁺, Ta⁵⁺, Th⁴⁺, Zr⁴⁺, Pb²⁺, Sr²⁺, Sn²⁺, Cu²⁺, or a combination thereof,
X is selected from the group consisting of a halogen anion, O²⁻, S²⁻, and a combination thereof;
preferably, the halogen anion includes at least one selected from the group consisting of F⁻, Cl⁻, Br⁻, and I⁻; and
preferably, the material with the ABX₃ structure is at least one or more selected from the group consisting of CH₃NH₃PbI₃, HN=CHNH₃PbI₃, and Csₓ((HN=CHNH₃)_{y} (CH₃NH₃)_{1-y})₁₋ₓPb(I_{z}Br_{1-z})₃, where 0 < x ≤ 0.25, 0.5 < y ≤ 1, and 0.75 ≤ z < 1.

In a second aspect, the present application provides a fabrication method of a perovskite solar cell, including the following steps:
(a) a substrate is provided;
(b) an electron transport layer is formed on the substrate;
(c) a perovskite layer is formed on the electron transport layer; and
(d) a hole transport layer is formed on the perovskite layer, and an organic layer including a carbazole derivative is formed on the hole transport layer, where the hole transport layer includes an inorganic substance serving as a hole transport material;
   or

(a) a substrate is provided;
(b) a hole transport layer is formed on the substrate, and an organic layer including a carbazole derivative is formed on the hole transport layer, where the hole transport layer includes an inorganic substance serving as a hole transport material;
(c) a perovskite layer is formed on the organic layer on the hole transport layer; and
(d) an electron transport layer is formed on the perovskite layer.

Product characteristics such as materials, structures, and thicknesses of layers involved in the fabrication method of a perovskite solar cell provided in the second aspect may refer to the first aspect of the present application.

In the present application, the substrate may be a transparent or translucent electrically-conductive material. For example, the substrate is obtained by producing a transparent electrically-conductive oxide on a transparent glass. The transparent electrically-conductive oxide is selected from the group consisting of an indium tin oxide (ITO), a zinc oxide, a doped tin oxide, and a doped zinc oxide, such as ITO, a fluorine-doped tin oxide (FTO), or an aluminum-doped tin oxide (AZO), etc, and preferably ITO. The transparent electrically-conductive oxide can include 90 wt% to 100 wt% of ITO, FTO, or AZO, and in some cases, the transparent electrically-conductive oxide can be composed primarily of ITO, FTO, or AZO. Typically, a thickness of the transparent electrically-conductive oxide is 50 nm to 600 nm, such as 100 nm, 200 nm, 300 nm, 400 nm, or 500 nm. The transparent electrically-conductive oxide can be used to form a bottom electrode layer of a perovskite solar cell. Thus, a glass with an ITO layer can be the substrate.

A method for forming the electron transport layer includes, but is not limited to, a radio frequency magnetron sputtering method, a spin-coating method, a spray-pyrolysis method, an atomic layer deposition (ALD) method, and a thermal oxidation method, etc. In an embodiment, the radio frequency magnetron sputtering is adopted. For example, a powdery C₆₀ fullerene is used as a raw material to prepare an electron transport layercontaining C₆₀ fullerene through vacuum thermal evaporation.

A method for forming the perovskite layer includes, but is not limited to, a one-step spin-coating method, a step-by-step immersion method, a two-step spin-coating method, and a vapor deposition method.

A method for forming the hole transport layer includes, but is not limited to, a solution method, a sol-gel method, and a radio frequency magnetron sputtering method.

A method for forming the organic layer including the carbazole derivative can be as follows: the carbazole derivative is dissolved in an organic solvent such as ethanol and propanol to obtain a carbazole derivative solution, and then the carbazole derivative solution is spin-coated on the hole transport layer and then heated or annealed.

The methods for forming the electron transport layers, the perovskite layer, and the hole transport layer can refer to "Perovskite Solar Cells" edited by Xiao Lixin et al. (Peking University Press, October 2016, 1st edition).

In a third aspect, the present application provides a perovskite solar cell, including:
a P-type or N-type crystalline silicon solar cell as a substrate; and
an electron transport layer, a perovskite layer, and a hole transport layer or a hole transport layer, a perovskite layer, and an electron transport layer that are formed successively on a primary surface of the P-type or N-type crystalline silicon solar cell,
where the hole transport layer includes an inorganic substance serving as a hole transport material, and an organic layer including a carbazole derivative is formed on the hole transport layer.

Product characteristics such as materials, structures, and thicknesses of layers involved in the perovskite solar cell provided in the third aspect may refer to the first aspect of the present application.

Preferably, the P-type or N-type crystalline silicon solar cell is a heterojunction solar cell. In addition, the P-type or N-type crystalline silicon solar cell can be selected from the group consisting of a heterojunction solar cell (HIT, SHJ, Heterojunction with Intrinsic Thin film), a passivated emitter and rear contact (PERC) cell, an interdigitated back contact (IBC) cell, a metal wrap through (MWT) cell, and a tunnel oxide passivated contact (Top-con) cell. Preferably, the P-type or N-type crystalline silicon solar cell is a heterojunction solar cell.

In an embodiment, the perovskite solar cell includes an inverted structure, that is, the perovskite solar cell includes a backside electrode, a hole transport layer, a perovskite layer, an electron transport layer, and a frontside electrode sequentially from bottom to top.

In an embodiment, the perovskite solar cell includes a regular structure, that is, the perovskite solar cell includes a backside electrode, an electron transport layer, a perovskite layer, a hole transport layer, and a frontside electrode sequentially from bottom to top.

It should be understood that the perovskite solar cell in the present application is not limited to the layer structures listed above, and can also include various modification layers, passivation layers, or the like known in the art and various variations of the above structures.

In an embodiment, the perovskite solar cell in the present application has an inverted structure, and specifically includes a bottom electrode (a backside electrically-conductive grid wire), a backside transparent electrically-conductive layer, a P-type amorphous silicon layer, a first intrinsic amorphous silicon layer, an N-type crystalline silicon substrate, a second intrinsic amorphous silicon layer, an N-type amorphous silicon layer, an intermediate transparent electrically-conductive layer, a hole transport layer, an organic layer including a carbazole derivative, a perovskite layer, an electron transport layer (which may include a first electron transport layer and a second electron transport layer), a frontside transparent electrically-conductive layer, and a top electrode (a frontside electrically-conductive grid wire) sequentially from bottom to top.

Examples of the perovskite solar cell and the fabrication method thereof in the present application are provided below.

### Example 1

In Example 1, a first perovskite solar cell and a fabrication method thereof are provided.

FIG. 1 is a schematic structural diagram of the first perovskite solar cell provided in Example 1. As shown in FIG. 1, the first perovskite solar cell 1 includes a bottom electrode layer 11, a hole transport layer 12, an organic layer 13 including a carbazole derivative, a perovskite layer 14, a first electron transport layer 15, a second electron transport layer 16, and a top electrode layer 17 sequentially from bottom to top.

A material of the bottom electrode layer 11 is ITO, and the bottom electrode layer has a thickness of about 135 nm. A material of the hole transport layer 12 is nickel oxide, and the hole transport layer has a thickness of 10 nm to 30 nm, such as 15 nm, 20 nm, or 30 nm. A material of the organic layer 13 including the carbazole derivative is [2-(9H-carbazol-9-yl)ethyl]phosphonic acid (2PACz) with a molecular formula as follows:

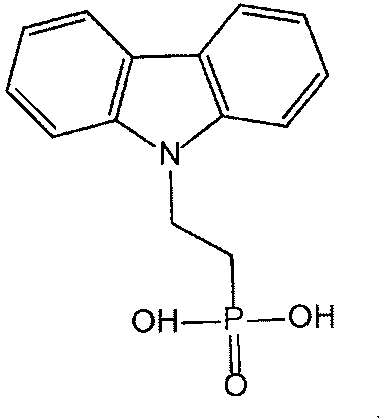

The organic layer 13 including the carbazole derivative has a thickness of 1 nm to 2 nm. The organic layer 13 including the carbazole derivative modifies a surface of the hole transport layer 12. A material of the perovskite layer 14 can be Cs_{0.05}MA_{0.1}FA_{0.85}Pb(I_{0.85}Br_{0.15})₃, where MA represents HN=CHNH₃⁺ and FA represents CH₃NH₃⁺. The perovskite layer 14 has a thickness of 300 nm to 700 nm, such as 400 nm, 500 nm, or 600 nm. A material of the first electron transport layer 15 is a fullerene with 60 carbon atoms (a C₆₀ fullerene), and the first electron transport layer has a thickness of 10 nm to 30 nm, such as 15 nm, 20 nm, or 25 nm. A material of the second electron transport layer 16 is tin oxide, and the second electron transport layer has a thickness of 10 nm to 30 nm, such as 15 nm, 20 nm, or 25 nm. A material of the top electrode layer 17 is silver, and the top electrode layer has a thickness of 100 nm.

The first perovskite solar cell shown in FIG. 1 could be fabricated according to the following steps:
1. A nickel oxide layer with a thickness of 20 nm was fabricated on a cleaned glass substrate with an ITO layer (a bottom electrode layer 11) through radio frequency magnetron sputtering with a nickel oxide target having a diameter of 2 inches and a thickness of 4 mm, a deposition pressure of 0.5 Pa, and an argon flow rate of 20 sccm (standard-state cubic centimeter per minute) to produce the hole transport layer 12. The glass substrate with the ITO layer (a bottom electrode layer 11) was purchased from South China Xiangcheng Technology Co., Ltd. The glass substrate is for experiments, and has a size of 15 mm × 15 mm × 1.1 mm and a sheet resistance of less than 15 Ω/□. The ITO layer has a thickness of 135 nm and is light-red. Oxygen is present on a surface of nickel oxide, and oxygen is highly electronegative. If there is free water or bound water on a surface of nickel oxide, oxygen atoms among crystal lattices can easily bind to the free water or bound water to produce surface hydroxyl.
2. A solution of 2PACz in ethanol was spin-coated on a surface of the nickel oxide layer at a speed of 3,000 rpm, and then annealed at 100°C for 1 min to produce the organic layer 13 including the carbazole derivative. A concentration of 2PACz in the solution is 1 mg/mL. The organic layer 13 including the carbazole derivative has a thickness of about 1 nm to 2 nm.
3. A lead iodide and cesium bromide layer with a thickness of 400 nm was formed on the organic layer 13 including the carbazole derivative through vacuum vapor deposition at 320°C with a vapor deposition rate ratio of 6:1, and then a solution of FAI, MACl, and MABr in ethanol was spin-coated at a speed of 1,500 rpm on the lead iodide layer, and then annealed at 150°C for 30 min to produce the perovskite layer14. Concentrations of FAI, MACl, and MABr in the solution are 50 mg/mL, 10 mg/mL, and 10 mg/mL, respectively.
4. A powdery C₆₀ fullerene was deposited on the perovskite layer 14 through vacuum thermal evaporation with an evaporation rate of 0.02 nm/s and a deposition thickness of 10 nm to produce a C₆₀ fullerene electron transport layer.
5. A tin oxide layer was prepared on the first electron transport layer 15 through ALD with tetrakis(dimethylamino)tin (TDMASn) as an organic tin source, pure water as an oxygen source, and a deposition thickness of 15 nm to produce the second electron transport layer 16.
6. A silver electrode layer with a thickness of 100 nm was prepared on the tin oxide layer through thermal evaporation to produce the top electrode layer 17 as a cathode of the perovskite solar cell. The thermal evaporation of a metal source generally does not have a restriction on a temperature, and can be allowed by directly heating, and the deposition thickness can be determined by observing a deposition rate.
7. A part of deposited film layers was scraped off to expose the electrode of the glass substrate with ITO, and an indium electrode was welded on ITO as a positive electrode.

### Example 2

In Example 2, a second perovskite solar cell and a fabrication method thereof are provided.

FIG. 2 is a schematic structural diagram of the second perovskite solar cell provided in Example 2. As shown in FIG. 2, the second perovskite solar cell 2 includes a backside electrically-conductive grid wire 201, a backside transparent electrically-conductive layer (a bottom electrode layer) 202, a P-type amorphous silicon layer 203, a first intrinsic amorphous silicon layer 204, an N-type silicon substrate 205, a second intrinsic amorphous silicon layer 206, an N-type amorphous silicon layer 207, an intermediate transparent electrically-conductive layer 208, a hole transport layer 209, an organic layer 210 including a carbazole derivative, a perovskite layer 211, a first electron transport layer 212, a second electron transport layer 213, a frontside transparent electrically-conductive layer 214, and a frontside electrically-conductive grid wire 215 sequentially from bottom to top.

The P-type amorphous silicon layer 203, the first intrinsic amorphous silicon layer 204, the N-type silicon substrate 205, the second intrinsic amorphous silicon layer 206, and the N-type amorphous silicon layer 207 constitute a semiconductor layer of a heterojunction cell.

The backside electrically-conductive grid wire 201 is a silver grid wire. The silver grid wire has a height of 20 µm and a width of 50 µm. A distance between every two silver grid wires is 2 mm.

The backside transparent electrically-conductive layer (a bottom electrode layer) 202 is electrically connected to the backside electrically-conductive grid wire 201. A material of the backside transparent electrically-conductive layer (a bottom electrode layer) 202 is ITO, and the backside transparent electrically-conductive layer has a thickness of 80 nm to 120 nm.

The P-type amorphous silicon layer 203 has a thickness of 8 nm to 10 nm.

The first intrinsic amorphous silicon layer 204 has a thickness of 8 nm to 10 nm, such as 8 nm, 9 nm, or 10 nm. The first intrinsic amorphous silicon layer is usually used as an i layer in a heterojunction cell.

The N-type silicon substrate 205 has a thickness of 250 µm. The N-type silicon substrate 205 is square, and has a size of 2 cm × 2 cm. The N-type silicon substrate 205 has a resistivity of 5 Ω·cm.

The second intrinsic amorphous silicon layer 206 has a thickness of 10 nm to 12 nm, such as 10 nm, 11 nm, or 12 nm. The second intrinsic amorphous silicon layer is usually used as an i layer in a heterojunction cell.

The N-type amorphous silicon layer 207 has a thickness of 8 nm to 15 nm.

A material of the middle transparent electrically-conductive layer 208 is ITO, and the middle transparent electrically-conductive layer has a thickness of 15 nm to 30 nm.

A material of the hole transport layer 209 is CuNiO, and the hole transport layer has a thickness of 20 nm to 50 nm.

A material of the organic layer 210 including the carbazole derivative is 2PACz.

A material of the perovskite layer 211 is Cs_{0.05}MA_{0.1}FA_{0.85}Pb(I_{0.85}Br_{0.15})₃.

A material of the first electron transport layer 212 is a fullerene with 60 carbon atoms (C₆₀), and the first electron transport layer has a thickness of 10 nm.

A material of the second electron transport layer 213 is tin oxide, and the second electron transport layer has a thickness of 15 nm.

A material of the frontside transparent electrically-conductive layer 214 is ITO, and the frontside transparent electrically-conductive layer has a thickness of 80 nm to 100 nm.

The frontside electrically-conductive grid wire 215 is a silver grid wire. The silver grid wire has a height of 20 µm and a width of 50 µm. A distance between every two silver grid wires is 2 mm.

The second perovskite solar cell shown in FIG. 2 could be fabricated according to the following steps:
1. Intrinsic amorphous silicon layers respectively with thicknesses of 8 nm and 10 nm were deposited on two primary surfaces of a sheet N-type silicon substrate with a thickness of 200 µm through plasma-enhanced chemical vapor deposition, respectively. The plasma-enhanced chemical vapor deposition was conducted under the following process conditions: first argon and then a silane and phosphine; a flow rate: 200 sccm; a radio frequency: 50 k to 15 MHz; a temperature: 200°C; and a power: 45 W. The N-type silicon substrate has a size of 2 cm × 2 cm and a resistivity of 5 Ω·cm. The N-type silicon substrate serves as N-type silicon substrate 205 in FIG. 2, and the formed intrinsic amorphous silicon layers serve as the first intrinsic amorphous silicon layer 204 and the second intrinsic amorphous silicon layer 206 in FIG. 2, respectively.
   It should be noted that the N-type silicon substrate is textured before deposition, that is, the N-type silicon substrate is corroded at 80°C for 15 min by a potassium hydroxide solution with a concentration of 2% to allow texturing.
2. P-type amorphous silicon was deposited on the first intrinsic amorphous silicon layer 204 with a thickness of 8 nm to produce the P-type amorphous silicon layer 203 with a thickness of 15 nm. N-type amorphous silicon was deposited on the second intrinsic amorphous silicon layer 206 with a thickness of 10 nm to produce the N-type amorphous silicon layer 207 with a thickness of 20 nm.
3. An ITO (targets: In : Sn = 90:10) layer with a thickness of 20 nm was prepared on the N-type amorphous silicon layer 207 through magnetron sputtering. The ITO layer serves as the intermediate transparent electrically-conductive layer 208 in FIG. 2.
4. ACuNiO (targets: Cu : Ni = 95:5) layer with a thickness of 30 nm was deposited on the ITO layer (the intermediate transparent electrically-conductive layer 208) through magnetron sputtering. The CuNiO layer serves as the hole transport layer 209 in FIG. 2.
5. A solution of 2PACz in ethanol was spin-coated at a speed of 3,000 rpm on a surface of the CuNiO layer (the hole transport layer 209), and then annealed at 100°C for 1 min to produce the organic layer 210 including the carbazole derivative. A concentration of 2PACz in the solution is 1 mg/mL.
6. Lead iodide and cesium bromide were deposited through thermal evaporation deposition on a surface of the organic layer 210 including the carbazole derivative at rates of 0.105 nm/s and 0.015 nm/s respectively to produce a lead iodide and cesium bromide film. FAI and MABr were dissolved in ethanol at a molar ratio of 10:1 to obtain a solution in which a total concentration of FAI and MABr was 1.5 mmol/mL, and after full dissolution, the solution was filtered through a polytetrafluoroethylene filter membrane with a pore size of 0.45 µm, then spin-coated at a rotational speed of 4,000 rpm on the lead iodide and cesium bromide film for 30 s, and then heated for 60 min at a temperature of 150°C and a relative humidity of 50% to produce the perovskite layer 211. The perovskite layer is a light-absorbing layer of the perovskite solar cell.
7. A fullerene with 60 (C₆₀) carbon atoms was deposited through thermal evaporation on the perovskite layer 211 to produce the first electron transport layer 212 with a thickness of 20 nm.
8. A tin oxide layer with a thickness of 20 nm was prepared through ALD on the first electron transport layer 212 to produce the second electron transport layer 213.
9. ITO layers respectively with thicknesses of 100 nm and 20 nm were prepared on the P-type amorphous silicon layer 203 and the second electron transport layer 213 respectively through reactive plasma deposition to produce the backside transparent electrically-conductive layer 202 and the frontside transparent electrically-conductive layer 214, respectively.
10. Silver grid wires were fabricated through screen printing on the backside transparent electrically-conductive layer 202 and the frontside transparent electrically-conductive layer 214, respectively. The silver grid wires have a height of 20 µm and a width of 50 µm. A distance among the silver grid wires is 2 mm.

### Example 3

Example 3 is different from Example 2 merely in that the solution of 2PACz in ethanol is replaced by a solution of Me-4PACz in ethanol in the step 5 of Example 3. A concentration of Me-4PACz in the solution is 1 mg/mL.

A chemical name of Me-4PACz is [4-(3,6-dimethyl-9H-carbazol-9-yl)butyl]phosphonic acid. A molecular formula of Me-4PACz is as follows:

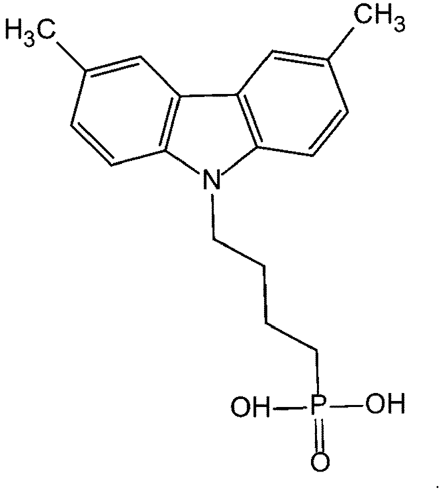

### Comparative Example 1

Comparative Example 1 is different from Example 1 merely in that the step 2 is omitted.

### Comparative Example 2

Comparative Example 2 is different from Example 2 merely in that the step 5 is omitted.

### Comparative Example 3

Comparative Example 3 is different from Example 2 merely in that the step 4 is omitted.

### Example 4

Example 4 is different from Example 2 merely in that, in the step 1, the N-type silicon substrate is not textured.

### Comparative Example 4

Comparative Example 4 is different from Example 1 merely in that, in the step 5, a solution of Spiro-TTB in ethanol is used instead of the solution of 2PACz in ethanol, and a same concentration is adopted. Vacuum thermal evaporation is adopted for the Spiro-TTB.

A chemical name of the Spiro-TTB is 2,2',7,7'-tetrakis(di-p-tolylamino)spiro-9,9'-difluorene or 2,2',7,7'-tetrakis(N,N-di-p-tolyl)amino-9,9-spirodifluorene.

### Comparative Example 5

Comparative Example 5 is different from Example 2 merely in that, in the step 5, a solution of Spiro-TTB in ethanol is used instead of the solution of 2PACz in ethanol, and a same concentration is adopted. Vacuum thermal evaporation is adopted for the Spiro-TTB.

### Performance test:

Performance of cells was tested under standard test conditions (AM 1.5, 25°C, and 1,000 W/m²), and a short-circuit current density (J_{sc}), an open-circuit voltage (V_{oc}), a conversion efficiency (Eff), and a fill factor (FF) were tested, separately. Performance test results of each example of the present application are shown in Table 1.

**Table 1 Comparison of IV performance (current and voltage performance) between each example and the comparative examples of the present application**

| Sample | Short-circuit current density (mA/cm²) | Open-circuit voltage (V) | Fill factor (%) | Conversion efficiency (%) |
|---|---|---|---|---|
| Example 1 | 22.17 | 1.10 | 80.83% | 19.71% |
| Example 2 | 19.85 | 1.80 | 77.93% | 27.83% |
| Example 3 | 19.93 | 1.81 | 79.51% | 28.68% |
| Comparative Example 1 | 22.30 | 1.01 | 79.28% | 17.85% |
| Comparative Example 2 | 19.87 | 1.70 | 78.60% | 26.55% |
| Comparative Example 3 | 20.09 | 1.77 | 68.41% | 24.32% |
| Example 4 | 16.52 | 1.85 | 81.07 | 24.78% |
| Comparative Example 4 | 21.80 | 1.07 | 78.23% | 18.24% |
| Comparative Example 5 | 19.58 | 1.76 | 76.99% | 26.53% |

It can be seen from the table that the solar cell with the hole transport layer of the present application has characteristics such as high conversion efficiency.

Although some embodiments of the present application have been described above, the contents described above are merely embodiments adopted for facilitating the understanding of the present application and are not intended to limit the protection scope of the present application. Those skilled in the art to which the present application belongs may make any modifications and changes to implementation forms and details without departing from the principle of the technical solutions disclosed in the present application, and such modifications and changes still fall within the protection scope of the present application.

## Claims

1. A perovskite solar cell, comprising an electron transport layer, a perovskite layer, and a hole transport layer, wherein the hole transport layer comprises an inorganic substance serving as a hole transport material, and an organic layer comprising a carbazole derivative is formed on the hole transport layer.

2. The perovskite solar cell according to claim 1, wherein a molecular formula of the carbazole derivative comprises a skeleton of carbazole molecule and an organic acid group directly or indirectly linked to nitrogen of the skeleton of carbazole molecule, wherein the organic acid group is preferably selected from the group consisting of phosphoryl, carboxyl, sulfonyl, sulfinyl, and thiocarboxyl, and a hydrogen atom on the skeleton of carbazole molecule is able to be substituted.

3. The perovskite solar cell according to claim 1 or 2, wherein the carbazole derivative is a compound shown in a molecular formula (I): 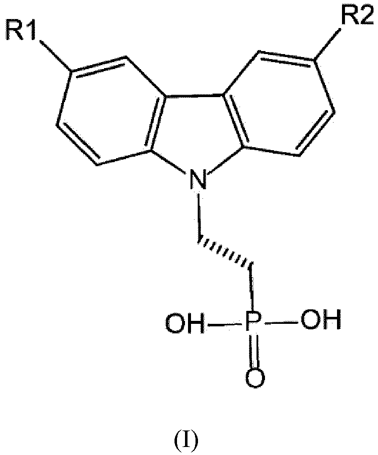
wherein R1 and R2 are independently selected from the group consisting of a hydrogen atom, alkyl, alkoxy, alkenyl, and alkynyl; R1 and R2 are the same or different; a dotted line represents a linking group; preferably, the linking group refers to a group linking a phosphorus atom and a nitrogen atom, for example, the linking group is selected from the group consisting of substituted or unsubstituted alkylene with 1 or more, preferably 2 or more, and more preferably 3 or more carbon atoms and substituted or unsubstituted alkenylene with 2 or more and preferably 3 or more carbon atoms, etc;
preferably, R1 and R2 are independently selected from the group consisting of methyl and methoxy; preferably, R1 and R2 both are methyl; and preferably, R1 and R2 both are a hydrogen atom.

4. The perovskite solar cell according to any one of claims 1 to 3, wherein the inorganic substance serving as the hole transport material is at least one or more selected from the group consisting of nickel oxide, cuprous iodide, cuprous thiocyanate, cupric oxide, cuprous oxide, and cupric sulfide.

5. The perovskite solar cell according to any one of claims 1 to 4, wherein a thickness of the hole transport layer is more than or equal to 1 nm and less than or equal to 100 nm, such as 2 nm, 3 nm, 4 nm, 5 nm, 6 nm, 7 nm, 8 nm, 9 nm, 10 nm, 20 nm, 30 nm, 40 nm, 50 nm, 60 nm, 70 nm, 80 nm, or 90 nm; and preferably, a thickness of the organic layer comprising the carbazole derivative is more than or equal to 0.01 nm and less than or equal to 5 nm, such as 4.5 nm, 4 nm, 3.5 nm, 3 nm, 2.5 nm, 2 nm, 1.5 nm, 1 nm, 0.5 nm, 0.3 nm, 0.2 nm, or 0.1 nm.

6. The perovskite solar cell according to any one of claims 1 to 5, wherein the inorganic substance serving as the hole transport material comprises nickel oxide; and preferably, the inorganic substance serving as the hole transport material is a material mainly based on nickel oxide, and is not doped with or is doped with any one or more selected from the group consisting of trivalent nickel, copper, cobalt, manganese, lanthanum, yttrium, magnesium, lithium, zinc, indium, and tin.

7. The perovskite solar cell according to any one of claims 1 to 6, wherein the electron transport layer comprises a first electron transport layer and/or a second electron transport layer; preferably, the first electron transport layer and/or the second electron transport layer comprise(s) an inorganic substance and/or an organic substance serving as an electron transport material; preferably, the inorganic substance is at least one or more selected from the group consisting of titanium dioxide, tin oxide, and zinc oxide; and preferably, the organic substance is at least one or more selected from the group consisting of a fullerene and a derivative thereof, and more preferably, the fullerene is selected from the group consisting of a fullerene with 60 carbon atoms (C₆₀ fullerene) and a fullerene with 70 carbon atoms (C₇₀ fullerene).

8. The perovskite solar cell according to any one of claims 1 to 7, wherein the perovskite layer comprises a layer of a material with an ABX₃ structure, wherein
A is a first cation, comprising, but not limited to, any one or a combination of two or more selected from the group consisting of Rb⁺, Na⁺, K⁺, Ca²⁺, Ba²⁺, Cs⁺, HN=CHNH₃⁺, CH₃NH₃⁺, Pb²⁺, Sr²⁺, and Sn²⁺,
B is a second cation, comprising, but not limited to, any one or a combination of two or more selected from the group consisting of Ti⁴⁺, Nb⁵⁺, Mn⁴⁺, Fe³⁺, Ta⁵⁺, Th⁴⁺, Zr⁴⁺, Pb²⁺, Sr²⁺, Sn²⁺, and Cu²⁺.
X is any one or a combination of two or more selected from the group consisting of a halogen anion, O²⁻, and S²⁻;
preferably, the halogen anion comprises at least one selected from the group consisting of F⁻, Cl⁻, Br⁻, and I⁻; and
preferably, the material with the ABX₃ structure is at least one or more selected from the group consisting of CH₃NH₃Pbl₃, HN=CHNH₃PbI₃, and Csₓ((HN=CHNH₃)_{y} (CH₃NH₃)_{1-y})₁₋ₓPb(I_{z}Br_{1-z})₃, wherein 0 < x ≤ 0.25, 0.5 < y ≤ 1, and 0.75 ≤ z < 1.

9. A fabrication method of a perovskite solar cell, comprising the following steps:
(a) providing a substrate;
(b) forming an electron transport layer on the substrate;
(c) forming a perovskite layer on the electron transport layer; and
(d) forming a hole transport layer on the perovskite layer, and forming an organic layer comprising a carbazole derivative on the hole transport layer, wherein the hole transport layer comprises an inorganic substance serving as a hole transport material;
or
(a) providing a substrate;
(b) forming a hole transport layer on the substrate, and forming an organic layer comprising a carbazole derivative on the hole transport layer, wherein the hole transport layer comprises an inorganic substance serving as a hole transport material;
(c) forming a perovskite layer on the organic layer on the hole transport layer; and
(d) forming an electron transport layer on the perovskite layer.

10. The fabrication method according to claim 9, wherein a molecular formula of the carbazole derivative comprises a skeleton of carbazole molecule and an organic acid group directly or indirectly linked to nitrogen of the skeleton of carbazole molecule, wherein the organic acid group is preferably selected from the group consisting of phosphoryl, carboxyl, sulfonyl, sulfinyl, and thiocarboxyl, and a hydrogen atom on the skeleton of carbazole molecule is able to be substituted.

11. The fabrication method according to claim 9 or 10, wherein the carbazole derivative is a compound shown in a molecular formula (I): 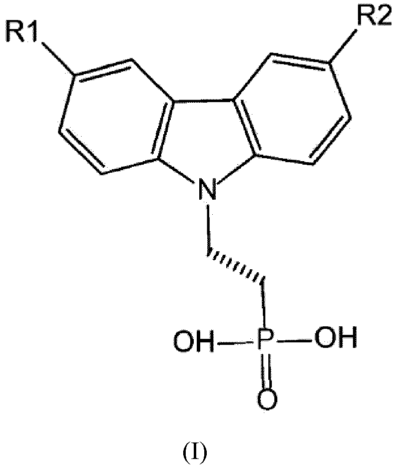
wherein R1 and R2 are independently selected from the group consisting of a hydrogen atom, alkyl, alkoxy, alkenyl, and alkynyl; R1 and R2 are the same or different; a dotted line represents a linking group; preferably, the linking group refers to a group linking a phosphorus atom and a nitrogen atom, for example, the linking group is selected from the group consisting of substituted or unsubstituted alkylene with 1 or more, preferably 2 or more, and more preferably 3 or more carbon atoms and substituted or unsubstituted alkenylene with 2 or more and preferably 3 or more carbon atoms, etc;
preferably, R1 and R2 are independently selected from the group consisting of methyl and methoxy; preferably, R1 and R2 both are methyl; and preferably, R1 and R2 both are a hydrogen atom.

12. A perovskite solar cell, comprising:
a P-type or N-type crystalline silicon solar cell as a substrate; and
an electron transport layer, a perovskite layer, and a hole transport layer or a hole transport layer, a perovskite layer, and an electron transport layer that are formed successively on a primary surface of the P-type or N-type crystalline silicon solar cell,
wherein the hole transport layer comprises an inorganic substance serving as a hole transport material, and an organic layer comprising a carbazole derivative is formed on the hole transport layer.

13. The perovskite solar cell according to claim 12, wherein a molecular formula of the carbazole derivative comprises a skeleton of carbazole molecule and an organic acid group directly or indirectly linked to nitrogen of the skeleton of carbazole molecule, wherein the organic acid group is preferably selected from the group consisting of phosphoryl, carboxyl, sulfonyl, sulfinyl, and thiocarboxyl, and a hydrogen atom on the skeleton of carbazole molecule is able to be substituted.

14. The perovskite solar cell according to claim 12 or 13, wherein the carbazole derivative is a compound shown in a molecular formula (I): 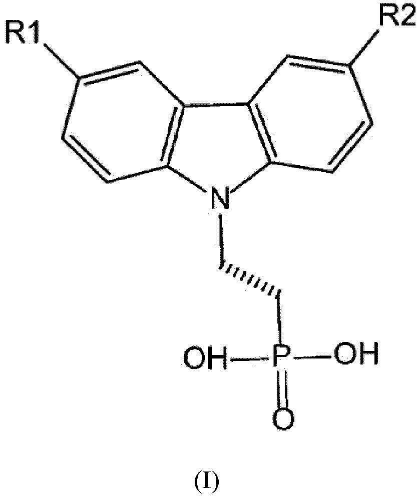
wherein R1 and R2 are independently selected from the group consisting of a hydrogen atom, alkyl, alkoxy, alkenyl, and alkynyl; R1 and R2 are the same or different; a dotted line represents a linking group; preferably, the linking group refers to a group linking a phosphorus atom and a nitrogen atom, for example, the linking group is selected from the group consisting of substituted or unsubstituted alkylene with 1 or more, preferably 2 or more, and more preferably 3 or more carbon atoms and substituted or unsubstituted alkenylene with 2 or more and preferably 3 or more carbon atoms, etc;
preferably, R1 and R2 are independently selected from the group consisting of methyl and methoxy; preferably, R1 and R2 both are methyl; and preferably, R1 and R2 both are a hydrogen atom.

15. The perovskite solar cell according to any one of claims 12 to 14, wherein the P-type or N-type crystalline silicon solar cell is a heterojunction solar cell.
